# EUROPEAN PATENT APPLICATION

(11) **EP 4 404 246 A1**
(43) Date of publication of application: **24.07.2024**
(21) Application number: 24151173.2
(22) Date of filing: 10.01.2024
(51) Int. Cl.: H01L 21/56, H01L 23/16, H01L 23/00, H01L 23/58, H01L 25/065, H01L 23/31, H01L 23/498

(54) **SEMICONDUCTOR PACKAGE AND FABRICATION METHOD THEREOF**

(30) Priority: 18.01.2023 US 202363480319 P; 17.12.2023 US 202318542762
(71) Applicant: MediaTek Inc., Hsin-Chu 300 (TW)
(72) Inventor: TSAO, Pei-Haw, 30078 Hsinchu City (TW); WONG, Te-Chi, 30078 Hsinchu City (TW)
(74) Representative: Hoefer & Partner Patentanwälte mbB

(57) **Abstract**

A semiconductor package (1) includes a package substrate (20), an interposer (200) on and electrically connected to the package substrate (20), a central logic die (101) disposed on and electrically connected to the interposer (200), peripheral function dies (102) disposed on and electrically connected to the interposer (200) and located in proximity to the central logic die (101), and at least one dummy die (103) disposed between the central logic die (101) and the peripheral function dies (102) so as to form a rectangular shaped die arrangement. The at least one dummy die (103) is disposed at a corner position of the rectangular shaped die arrangement.

## Description

### Cross Reference to Related Applications

This application claims the benefit of U.S. Provisional Application No. 63/480,319, filed on January 18th, 2023. The content of the application is incorporated herein by reference.

### Background

The present disclosure relates generally to the field of semiconductor packaging. More particularly, the present disclosure relates to a package and a method for making the same.

As known in the art, Chip-on-Wafer-on-Substrate (CoWoS) is a 2.5D wafer-level multi-chip packaging technology that incorporates multiple dies side-by-side on a silicon interposer substrate in order to achieve better interconnect density and performance. Individual chips are bonded through micro-bumps on the silicon interposer substrate forming a chip-on-wafer (CoW). The CoW is then subsequently thinned such that the through substrate via (TSV) perforations are exposed. C4 bumps formation and singulation are then carried out. A CoWoS package is completed through bonding to a package substrate.

The prior art CoWoS packages have a drawback in that the fatigue failure such as underfill delamination may be observed at the package corners during or after the temperature cycle testing (TCT). The underfill delamination may cause reliability issues. Therefore, there is a need in this technical field to provide an improved CoWoS package with increased reliability pass rate.

### Summary

It is one object of the present disclosure to provide an improved semiconductor package in order to solve the prior art deficiencies or shortcomings. A semiconductor package according to the invention is defined in claim 1. The dependent claims define preferred embodiments thereof.

One aspect of the invention provides a semiconductor package including a package substrate; an interposer disposed on and electrically connected to the package substrate; at least one central logic die disposed on and electrically connected to the interposer; a plurality of peripheral function dies disposed on and electrically connected to the interposer and located in proximity to the at least one central logic die; and at least one dummy die disposed between the at least one central logic die and the plurality of peripheral function dies so as to form a rectangular shaped die arrangement. The at least one dummy die is disposed at a corner position of the rectangular shaped die arrangement. A first underfill is filled into a gap between the at least one central logic die and the interposer, a gap between the plurality of peripheral function dies and the interposer, a gap between the at least one dummy die and the interposer, a gap between the at least one central logic die and the plurality of peripheral function dies, and a gap between the at least one central logic die and the at least one dummy die. An epoxy molding compound encapsulates the at least one central logic die, the plurality of peripheral function dies, and the at least one dummy die. A second underfill is filled into a gap between the interposer and the package substrate.

Preferably, the at least one dummy die comprises an adhesion polymer layer disposed on its bonding surface.

Preferably, the adhesion polymer layer comprises polyimide (PI) or polybenzoxazole (PBO).

Preferably, the adhesion polymer layer is disposed on a passivation layer, wherein the adhesion polymer layer covers a perimeter of an under-bump metal metallurgy (UBM) of a pad of the at least one dummy die.

Preferably, the at least one central logic die comprises a system-on-chip (SoC), a central processing unit (CPU) die, a graphic processing unit (GPU) die, an RF die, or an application processor (AP) die.

Preferably, the plurality of peripheral function dies comprises memory dies.

Preferably, the at least one dummy die comprises a silicon die.

Preferably, the at least one dummy die comprises ceramic, metal, polymer, or thermal conductive materials.

Preferably, a size of the interposer is greater than 1.5 reticle size, wherein 1 reticle size is 26mm × 34mm.

Preferably, the interposer comprises a silicon interposer and comprises a plurality of through silicon vias.

Preferably, the interposer comprises organic material.

Preferably, the at least one central logic die, the plurality of peripheral function dies, and the at least one dummy die have substantially the same die thickness.

Preferably, the at least one central logic die is mounted on the interposer through first micro-bumps, the plurality of peripheral function dies is mounted on the interposer through second micro-bumps, and the at least one dummy die is mounted on the interposer through third micro-bumps.

Preferably, the first, second, and third micro-bumps are surrounded by the first underfill.

Preferably, the interposer is connected to the package substrate through flip chip bumps or C4 bumps.

Preferably, the flip chip bumps or C4 bumps are surrounded by the second underfill.

Preferably, the semiconductor package further comprises a stiffener ring mounted on a top surface of the package substrate.

Preferably, the stiffener ring comprises metal.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 is a schematic chip placement diagram of an exemplary CoWoS package in accordance with one embodiment of the invention;
FIG. 2 is a cross-sectional view taken along line I-I' of FIG. 1;
FIG. 3 is an enlarged view of FIG. 2 showing the interface between the underfill and the dummy die; and
FIG. 4 to FIG. 12 are schematic diagrams showing an exemplary method for fabricating a semiconductor package according to an embodiment of the invention.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the scope of the present disclosure. The following detailed description is, therefore, not to be taken in a limiting sense, and the scope of embodiments of the present invention is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items. The term "dummy die", which is a non-function die, is referred to as a semiconductor die or chip that does not have any electrical function.

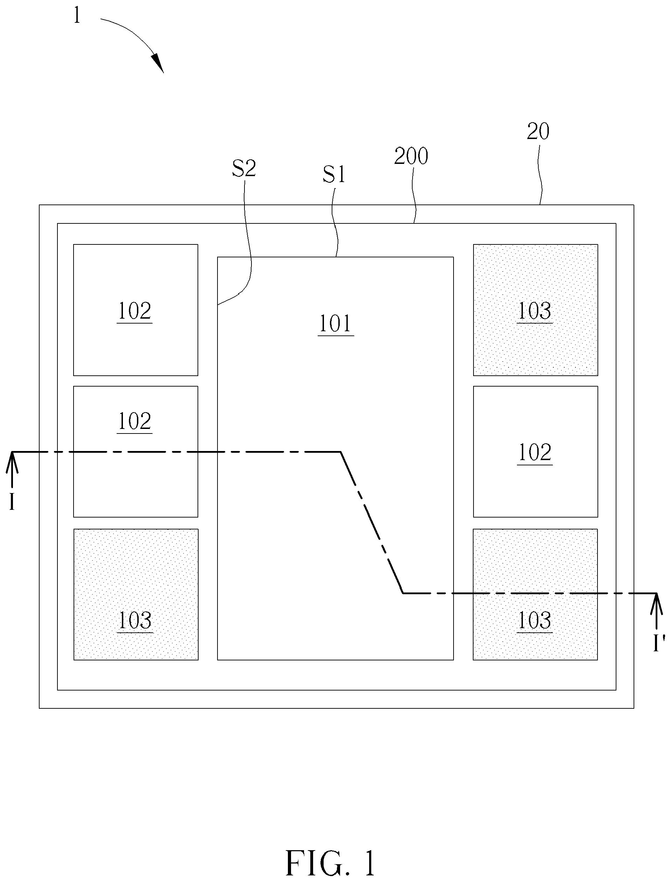

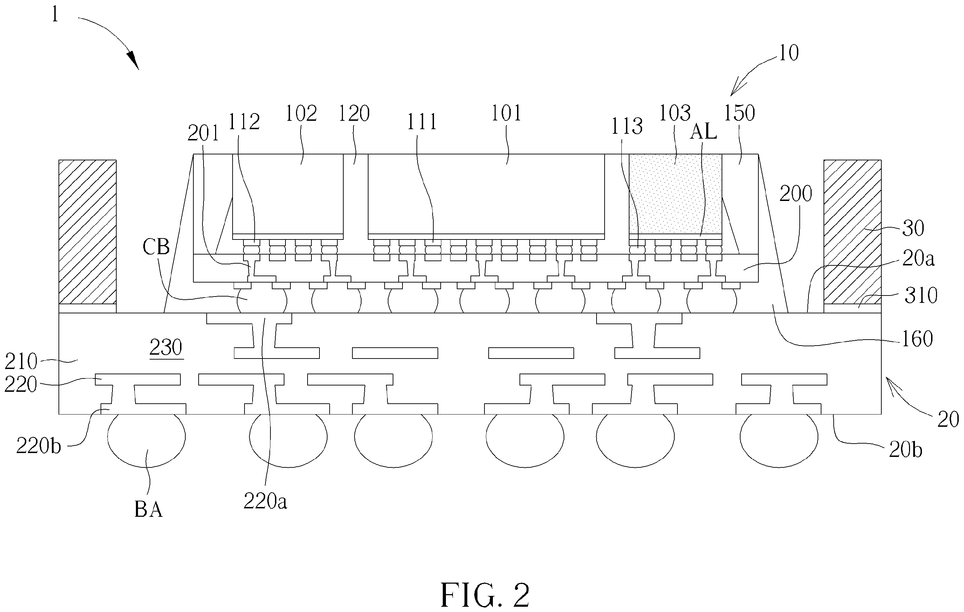

Please refer to FIG. 1 and FIG. 2. FIG. 1 is a schematic chip placement diagram of an exemplary CoWoS package in accordance with one embodiment of the invention. FIG. 2 is a cross-sectional view taken along line I-I' of FIG. 1. As shown in FIG. 1 and FIG. 2, the semiconductor package 1 such as a Chip-on-Wafer-on-Substrate (CoWoS) package may comprise at least one central logic die 101 and multiple peripheral function dies 102 disposed in proximity to the central logic die 101. At least one dummy die 103 is disposed between the central logic die 101 and the multiple peripheral function dies 102 to form a rectangular shaped die arrangement. Preferably, for example, the dummy die 103 may include, but is not limited to, a silicon die with a similar structure to the central logic die 101 or the peripheral function die 102, but does not have any electrical function. Preferably, the at least one dummy die 103 is disposed at a corner position of the rectangular shaped die arrangement.

As can be seen in FIG. 1, for example, the rectangular shaped die arrangement may be comprised of seven dies including, but not limited to, one larger central logic die 101 having a shorter side S1 and a longer side S2, three smaller, peripheral function dies 102 disposed along the longer side S2 of the central logic die 101, and three dummy dies 103 disposed at the respective three corners. Preferably, for example, the central logic die 101 may be a system-on-chip (SoC), a central processing unit (CPU) die, a graphic processing unit (GPU) die, an RF die, or an application processor (AP) die, but it not limited thereto.

Preferably, for example, the peripheral function dies 102 may comprise memory dies such as high-bandwidth memory (HBM) dies comprise of a stack of DRAM dies, but not limited thereto. Preferably, for example, the peripheral function dies 102 may be HBM2 or HBM3, but not limited thereto. HBM is a memory chip with low power consumption and ultra-wide communication lanes.

Preferably, for example, the dummy dies 103 may be passive silicon dies. Preferably, for example, the dummy dies 103 may comprise any suitable materials, for example, ceramic, metal, polymer, or thermal conductive materials.

As shown in FIG. 1 and FIG. 2, the central logic die 101, the peripheral function die 102, and the dummy die 103 are mounted on an interposer 200. Preferably, for example, the size of the interposer 200 may be greater than 1.5 reticle size, wherein 1 reticle size is 26mm × 34mm. Preferably, for example, the interposer 200 may be a silicon interposer and may comprise a plurality of through silicon vias (TSVs) 201. In some embodiments, the interposer 200 may comprise an organic material.

Preferably, for example, the central logic die 101 may be mounted on the interposer 200 through micro-bumps 111, the peripheral function die 102 may be mounted on the interposer 200 through micro-bumps 112, and the dummy die 103 may be mounted on the interposer 200 through micro-bumps 113. Preferably, for example, the micro-bumps 111, 112, 113 may comprise nickel, copper, gold, palladium, and/or SnAg solder. Preferably, for example, the central logic die 101, the peripheral function die 102, and the dummy die 103 may have substantially the same die thickness.

Preferably, for example, the gap between the central logic die 101 and the interposer 200, the gap between the peripheral function die 102 and the interposer 200, the gap between the dummy die 103 and the interposer 200, the gap between the central logic die 101 and the peripheral function die 102, and the gap between the central logic die 101 and the dummy die 103 are filled with an underfill 120. Preferably, for example, the micro-bumps 111, 112, 113 are surrounded by the underfill 120. In some embodiments, for example, the underfill 120 may be placed using a capillary flow process after the dies are attached to the interposer 200.

Preferably, for example, the dummy die 103 comprises adhesion polymer layer AL on its bonding surface to increase the adhesion ability between the dummy die and the underfill. The adhesion polymer layer AL can alleviate or avoid fatigue failure such as underfill delamination at the package corners during temperature cycle testing (TCT) of the semiconductor package 1.

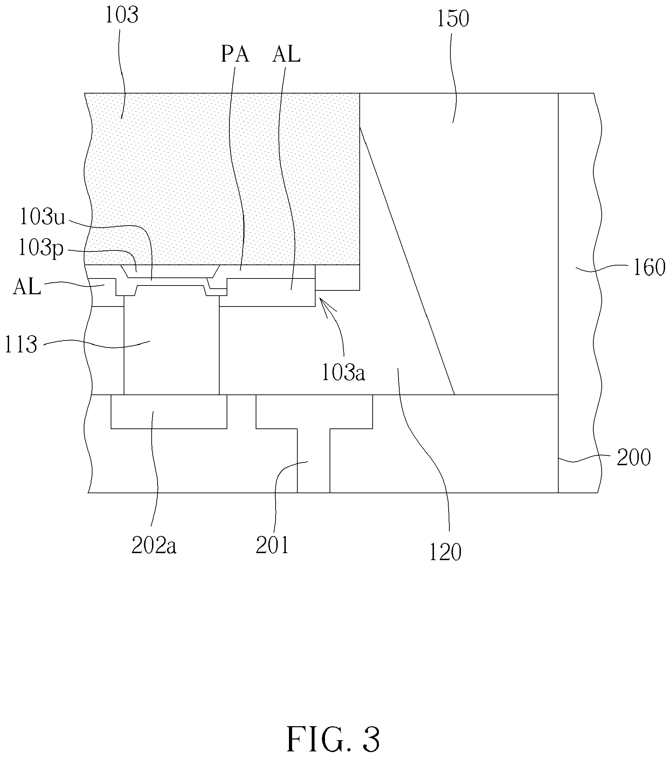

Please also refer to FIG. 3. FIG. 3 is an enlarged view showing the interface between the underfill 120 and the dummy die 103 within the dotted line area of FIG. 2, wherein like regions, layers or elements are designated by like numeral numbers or labels. Preferably, the adhesion polymer layer AL is the topmost layer on the bonding surface 103a of the dummy die 103 and the adhesion polymer layer AL is in direct contact with the underfill 120. Preferably, for example, the adhesion polymer layer AL may comprise polyimide (PI) or polybenzoxazole (PBO), but is not limited thereto. Preferably, the adhesion polymer layer AL may be formed on a passivation layer PA. Preferably, the adhesion polymer layer AL covers a perimeter of an under-bump metal metallurgy (UBM) 103u of a pad 103p of the dummy die 103. The micro-bump 113 is formed on the UBM 103u and is electrically connected to a connection pad 202a of the interposer 200.

Preferably, the central logic die 101, the peripheral function die 102, and the dummy die 103 may be encapsulated by an epoxy molding compound 150 on the interposer 200, thereby forming a Chip-on-Wafer (CoW) package 10. Preferably, the CoW package 10 may be mounted onto a top surface 20a of a package substrate 20. Preferably, for example, the CoW package 10 may be connected to the package substrate 20 through a plurality of flip chip bumps or C4 bumps CB.

Preferably, for example, the gap between the interposer 200 of the CoW package 10 and the package substrate 20 is filled with an underfill 160.Preferably, for example, the underfill 160 may be placed using a capillary flow process after the CoW package 10 is attached to the package substrate 20 having a dimension of, for example, greater than 60mm ×60mm..

Preferably, to cope with the warpage problem, a stiffener ring 30 such as a metal ring may be mounted on the top surface 20a of the package substrate 20 with an adhesive layer 310. Preferably, the package substrate 20 may comprise a core 210 that may be made of woven glass layers pre-impregnated with an epoxy resin material, such as the prepreg laminate FR-4 commonly used for printed circuit boards. Dielectric build-up layers 230 may be formed on two opposite sides of the core 210. Connection pads 220a, 220b and conductive copper traces 220 may be formed on the core 210 to provide the interconnection between the CoW package 10 and the system to which it is mounted. On the bottom surface 20b of the package substrate 20, a plurality of solder balls BA may be provided on the respective connection pads 220b.

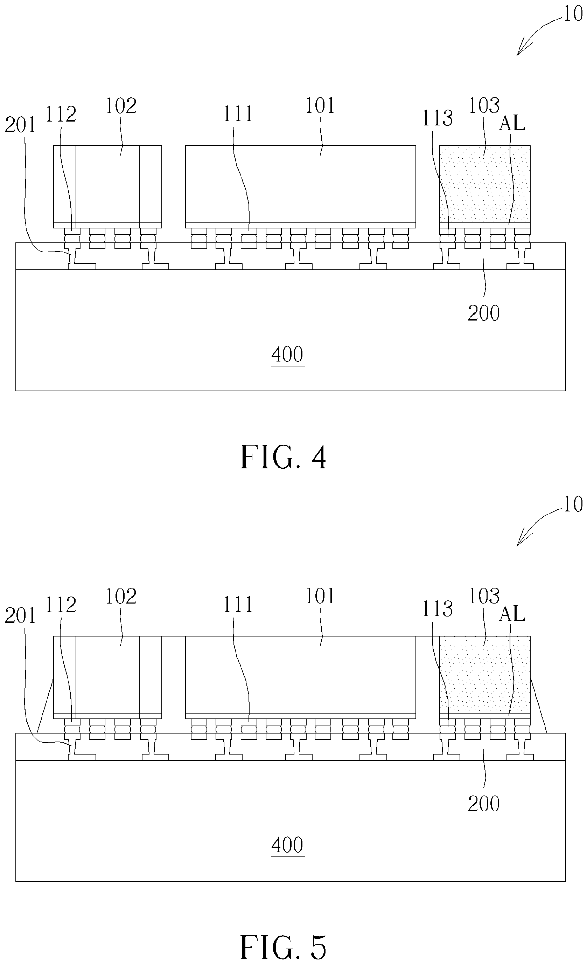

FIG. 4 to FIG. 12 are schematic diagrams showing an exemplary method for fabricating a semiconductor package according to an embodiment of the invention. As shown in FIG. 4, a carrier substrate 400 is provided. For example, the carrier substrate 400 may be a glass substrate, but is not limited thereto. An interposer 200 is formed on the carrier substrate 400. Preferably, for example, the interposer 200 may be a silicon interposer and may comprise a plurality of through silicon vias 201.Preferably, the interposer 200 may comprise an organic material. A central logic die 101, at least one peripheral function die 102, and at least one dummy die 103 are mounted on an interposer 200 in a flip-chip manner. Preferably, for example, the dummy die 103 comprises an adhesion polymer layer AL disposed on its bonding surface.

Preferably, for example, the central logic die 101 may be mounted on the interposer 200 through micro-bumps 111, the peripheral function die 102 may be mounted on the interposer 200 through micro-bumps 112, and the dummy die 103 may be mounted on the interposer 200 through micro-bumps 113. Preferably, for example, the micro-bumps 111, 112, 113 may comprise nickel, copper, gold, palladium, and/or SnAg solder. Preferably, for example, the central logic die 101, the peripheral function die 102, and the dummy die 103 may have substantially the same die thickness.

As shown in FIG. 5, the gap between the central logic die 101 and the interposer 200, the gap between the peripheral function die 102 and the interposer 200, the gap between the dummy die 103 and the interposer 200, the gap between the central logic die 101 and the peripheral function die 102, and the gap between the central logic die 101 and the dummy die 103 are filled with an underfill 120. Preferably, for example, the micro-bumps 111, 112, 113 are surrounded by the underfill 120.Preferably, for example, the underfill 120 may be placed using a capillary flow process after the dies are attached to the interposer 200.

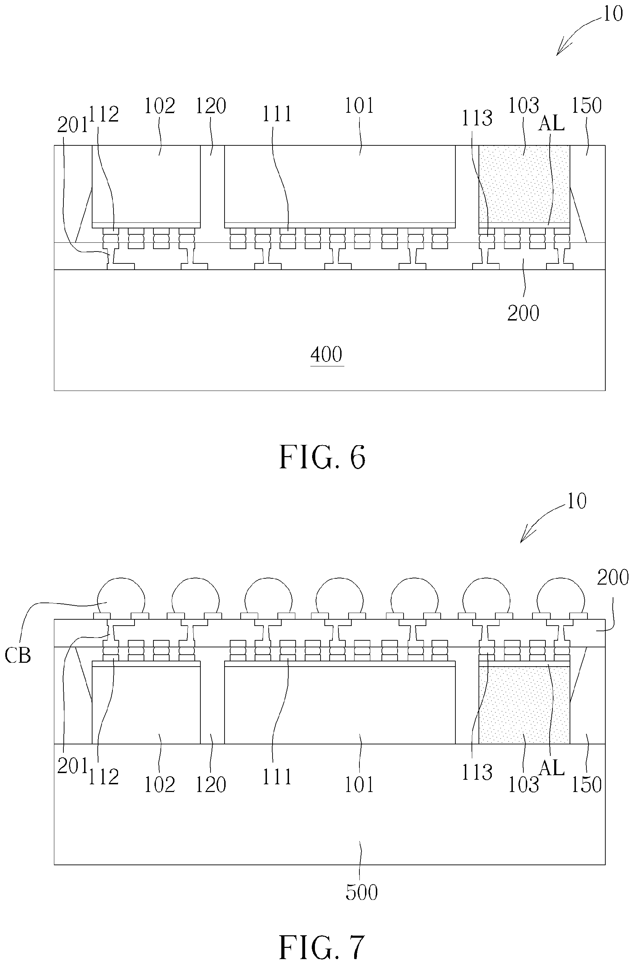

As shown in FIG. 6, the central logic die 101, the peripheral function die 102, and the dummy die 103 may be encapsulated by an epoxy molding compound 150 on the interposer 200.

As shown in FIG. 7, another carrier substrate 500 is attached to the exposed passive surfaces of the central logic die 101, the peripheral function die 102, and the dummy die 103. For example, the carrier substrate 500 may be a glass substrate, but is not limited thereto. Subsequently, the carrier substrate 400 is removed to expose a surface of the interposer 200. C4 bumps CB are then formed on the exposed surface of the interposer 200.

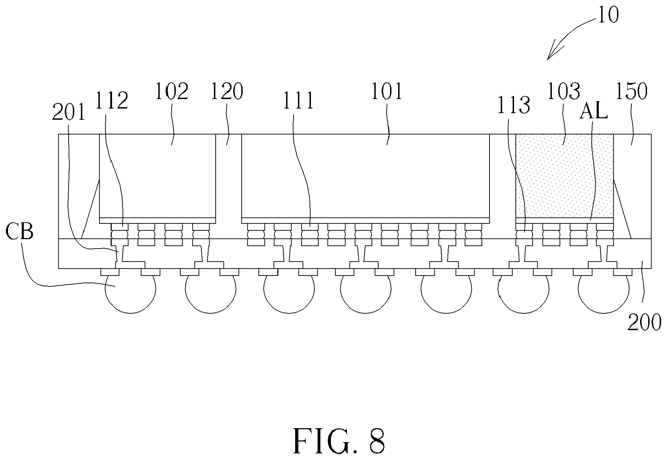

As shown in FIG. 8, after forming the C4 bumps CB, the carrier substrate 500 is removed, thereby forming a Chip-on-Wafer (CoW) package 10.

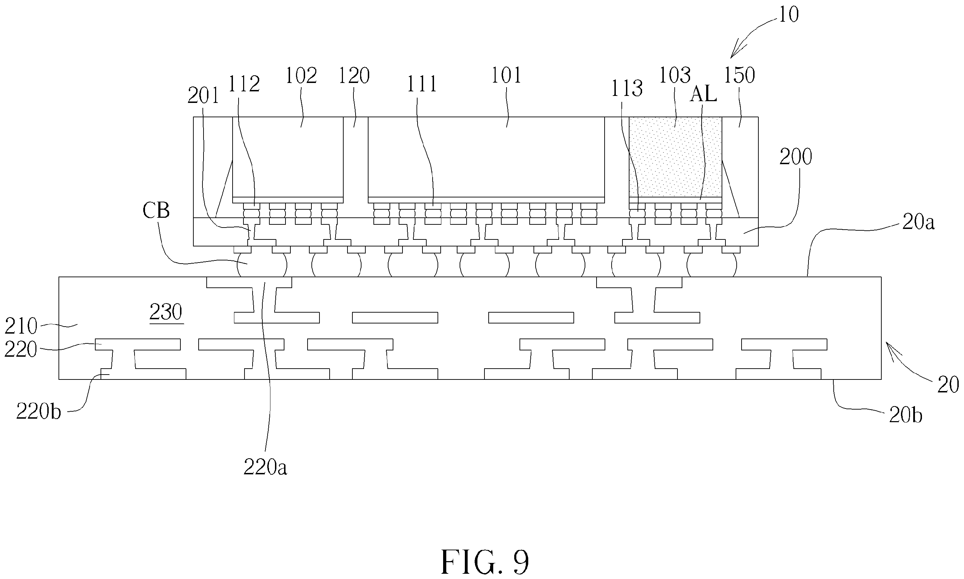

As shown in FIG. 9, the CoW package 10 is mounted onto a top surface 20a of a package substrate 20. Preferably, for example, the CoW package 10 may be connected to the package substrate 20 through the C4 bumps CB. The package substrate 20 has a dimension of, for example, greater than 60mm ×60mm.

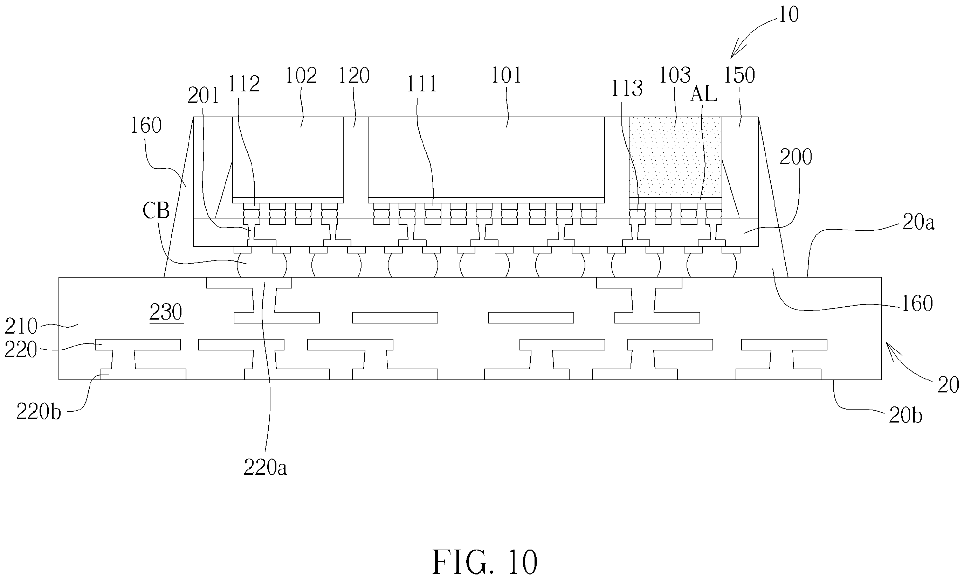

As shown in FIG. 10, the gap between the CoW package 10 and the package substrate 20 is filled with an underfill 160.Preferably, for example, the underfill 160 may be placed using a capillary flow process after the CoW package 10 is attached to the package substrate 20.

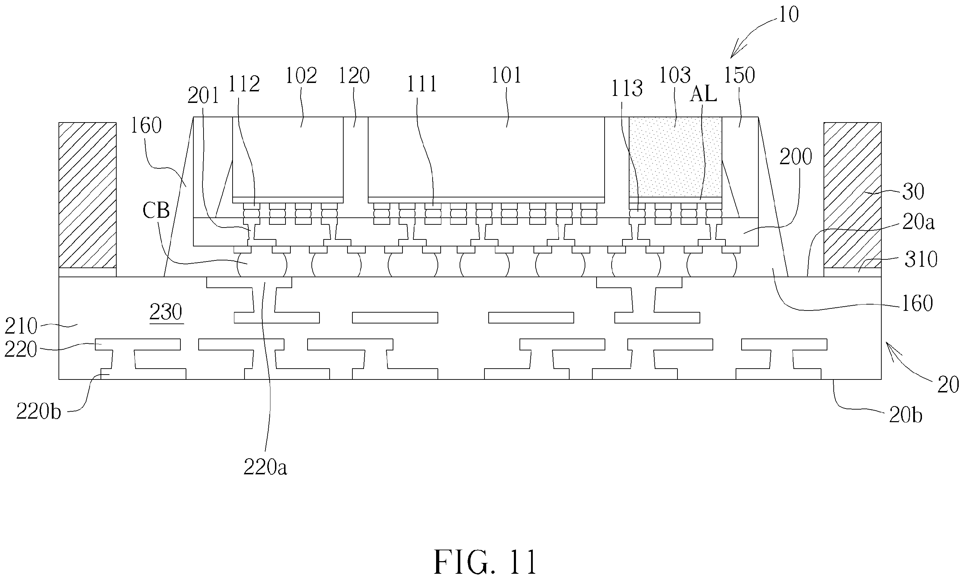

Subsequently, as shown in FIG. 11, a stiffener ring 30 such as a metal ring may be mounted on the top surface 20a of the package substrate 20 with an adhesive layer 310. Preferably, for example, the stiffener ring 30 may comprise copper, stainless steel, or aluminum, but is not limited thereto.

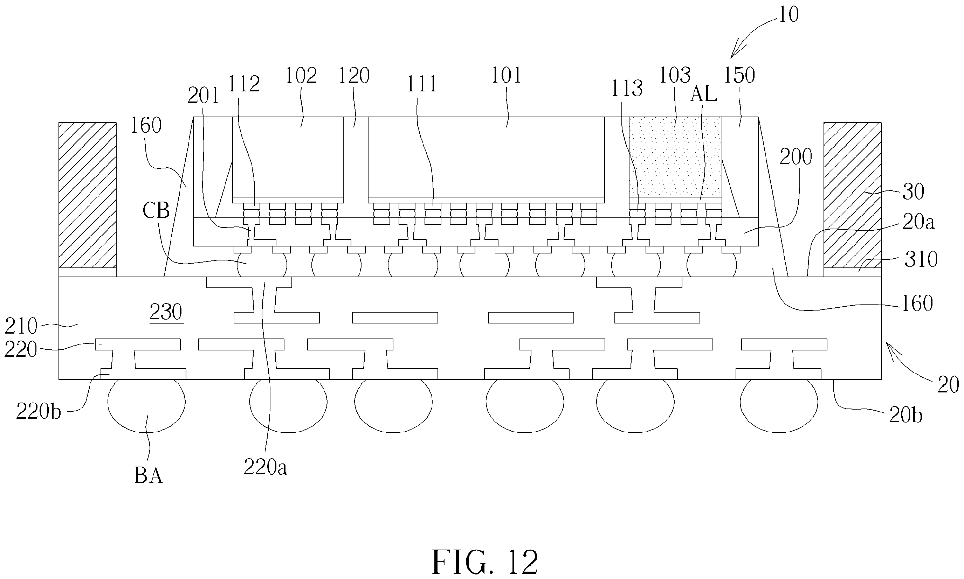

Subsequently, as shown in FIG. 12, a plurality of solder balls BA may be mounted on a bottom surface of the package substrate 20.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A semiconductor package (1), comprising:
a package substrate (20);
an interposer (200) disposed on and electrically connected to the package substrate (20);
at least one central logic die (101) disposed on and electrically connected to the interposer (200);
a plurality of peripheral function dies (102) disposed on and electrically connected to the interposer (200) and located in proximity to the at least one central logic die (101);
at least one dummy die (103) disposed between the at least one central logic die (101) and the plurality of peripheral function dies (102) so as to form a rectangular shaped die arrangement, wherein the at least one dummy die (103) is disposed at a corner position of the rectangular shaped die arrangement;
a first underfill (120) filling a gap between the at least one central logic die (101) and the interposer (200), a gap between the plurality of peripheral function dies (102) and the interposer (200), a gap between the at least one dummy die (103) and the interposer (200), a gap between the at least one central logic die (101) and the plurality of peripheral function dies (102), and a gap between the at least one central logic die (101) and the at least one dummy die (103);
an epoxy molding compound (150) encapsulating the at least one central logic die (101), the plurality of peripheral function dies (102), and the at least one dummy die (103); and
a second underfill (160) filling a gap between the interposer (200) and the package substrate (20).

2. The semiconductor package (1) according to claim 1, wherein the at least one dummy die (103) comprises an adhesion polymer layer (AL) disposed on its bonding surface (103a).

3. The semiconductor package (1) according to claim 2, wherein the adhesion polymer layer (AL) comprises polyimide, in the following also referred to as PI, or polybenzoxazole, in the following also referred to as PBO; and/or
wherein the adhesion polymer layer (AL) is disposed on a passivation layer (PA), wherein the adhesion polymer layer (AL) covers a perimeter of an under-bump metal metallurgy (103u) , in the following also referred to as UBM, of a pad (103p) of the at least one dummy die (103).

4. The semiconductor package (1) according to any one of claims 1 to 3, wherein the at least one central logic die (101) comprises a system-on-chip, in the following also referred to as SoC, a central processing unit, in the following also referred to as CPU, die, a graphic processing unit, in the following also referred to as GPU, die, an RF die, or an application processor, in the following also referred to as AP, die.

5. The semiconductor package (1) according to any one of claims 1 to 4, wherein the plurality of peripheral function dies (102) comprises memory dies.

6. The semiconductor package (1) according to any one of claims 1 to 5, wherein the at least one dummy die (103) comprises a silicon die; and/or
wherein the at least one dummy die (103) comprises ceramic, metal, polymer, or thermal conductive materials.

7. The semiconductor package (1) according to any one of claims 1 to 6, wherein a size of the interposer (200) is greater than 1.5 reticle size, wherein 1 reticle size is 26mm × 34mm.

8. The semiconductor package (1) according to any one of claims 1 to 7, wherein the interposer (200) comprises a silicon interposer and comprises a plurality of through silicon vias (201); and/or wherein the interposer (200) comprises organic material.

9. The semiconductor package (1) according to any one of claims 1 to 8, wherein the at least one central logic die (101), the plurality of peripheral function dies (102), and the at least one dummy die (103) have substantially the same die thickness.

10. The semiconductor package (1) according to any one of claims 1 to 9, wherein the at least one central logic die (101) is mounted on the interposer (200) through first micro-bumps (111), the plurality of peripheral function dies (102) is mounted on the interposer (200) through second micro-bumps (112), and the at least one dummy die (103) is mounted on the interposer (200) through third micro-bumps (113).

11. The semiconductor package (1) according to claim 10, wherein the first, second, and third micro-bumps (111, 112, 113) are surrounded by the first underfill (120).

12. The semiconductor package (1) according to any one of claims 1 to 11, wherein the interposer (200) is connected to the package substrate (20) through flip chip bumps or C4 bumps (CB).

13. The semiconductor package (1) according to claim 12, wherein the flip chip bumps or C4 bumps (CB) are surrounded by the second underfill (160).

14. The semiconductor package (1) according to any one of claims 1 to 13, further comprising:
a stiffener ring (30) mounted on a top surface (20a) of the package substrate (20).

15. The semiconductor package (1) according to claim 14, wherein the stiffener ring (30) comprises metal.
